Europäisches Patentamt

European Patent Office

Office européen des brevets

(19)

(11) Veröffentlichungsnummer: **0 057 244**
**B1**

(12) **EUROPÄISCHE PATENTSCHRIFT**

(45) Veröffentlichungstag der Patentschrift:
23.10.85

(51) Int. Cl.⁴: **H 05 K 7/20**

(21) Anmeldenummer: 81105888.2

(22) Anmeldetag: 25.07.81

(54) **Zur staubfreien Kühlung eines Schaltschrankes dienender Wärmetauscher.**

(30) Priorität: 02.12.80 DE 3045326

(43) Veröffentlichungstag der Anmeldung:
11.08.82 Patentblatt 82/32

(45) Bekanntmachung des Hinweises auf die Patenterteilung:
23.10.85 Patentblatt 85/43

(84) Benannte Vertragsstaaten:
AT BE CH FR GB IT LI LU NL SE

(56) Entgegenhaltungen:
DE - A - 1 791 170
DE - A - 2 744 664
FR - A - 2 078 558
FR - A - 2 385 243
GB - A - 801 919
US - A - 3 559 728

(73) Patentinhaber: Autz+Herrmann,
Karl-Benz-Strasse 10-12, D-6900 Heidelberg 1 (DE)

(72) Erfinder: Reinhard, Heinrich, Husarenstrasse 5,
D-6900 Heidelberg (DE)

(74) Vertreter: Rüger, Rudolf, Dr.-Ing.,
Webergasse 3 Postfach 348, D-7300 Esslingen/Neckar
(DE)

## Beschreibung

Die Erfindung bezieht sich auf einen zur staubfreien Kühlung eines Schaltschrankes mittels durch Gebläse geförderter Kühlluft dienenden und außen an der Schrankwand angeordneten Wärmetauscher mit flachen, dem einen durch den Schaltschrank hindurchgehenden Kühlluftkreislauf zugeordneten ersten Kanälen, zwischen denen flache, zu dem anderen, mit der Außenluft verbundenen Kühlluftkreislauf gehörende zweite Kanäle wärmeübertragend angeordnet sind. Dabei sind die Kanäle aus zu einem endseitig durch eine ebene Platte abgeschlossenen Paket zusammengefügten gleichen Platten mit hochgebogenen seitlichen Rändern und einem an einer Stirnseite hochgebogenen Rand gebildet, wobei das Plattenpaket derart angeordnet ist, daß die Ebenen der Platten rechtwinklig zur Wand des Schaltschrankes verlaufen, während auf die beiden Enden des Plattenpaketes jeweils die Gebläse enthaltende Kästen aufgesetzt sind, die zur Außenluft führende bzw. mit dem Inneren des Schaltschrankes verbundene Öffnungen aufweisen.

Dieser Wärmetauscher ist Gegenstand der älteren europäischen Patentanmeldung EP-A-29 577. Er hat den Vorteil, für einen Schaltschrank ein geschlossenes Bauelement zu bilden, das ohne an dem Schaltschrank einen größeren Raum einzunehmen, eine einwandfreie Luftführung gewährleistet und mit einem guten Wirkungsgrad arbeitet.

Insbesondere die dem mit der Außenluft in Verbindung stehenden Kühlluftkreislauf zugeordneten zweiten Kanäle unterliegen jedoch beim Betrieb in staubiger Umgebung einer gewissen Verschmutzung, so daß der Wärmetauscher von Zeit zu Zeit gereinigt werden muß. Die Reinigung des Wärmetauschers ist aber nicht ganz einfach und macht es unter Umständen notwendig, die ganze Baueinheit einschließlich der die Gebläse enthaltenden Kästen von der Schrankwand abzunehmen. Solche Kühlvorrichtungen für Schaltschränke sind auch bekannt aus den Schriften DE-A-2 744 664, FR-A-2 078 558 und US-A-3 559 728.

Aufgabe der Erfindung ist es deshalb, den eingangs genannten Wärmetauscher derart weiterzubilden, daß die Reinigung des verschmutzten oder verklebten Wärmetauschers in einfacher Weise möglich ist.

Diese Aufgabe wird erfindungsgemäß dadurch gelöst, daß das Plattenpaket mit den die Gebläse enthaltenden Kästen mittels Verschlußeinrichtungen verbunden ist, die bei auf der Schrankwand verbleibenden Kästen lösbar sind. Damit kann nach Lösen der Verschlußeinrichtungen das ganze Plattenpaket als Einheit abgenommen, beispielsweise in einem Lösungsmittelbad gereinigt, und sodann wieder eingesetzt werden. In extremen Verschmutzungsfällen ist auch ein Austausch des verschmutzten Plattenpaketes gegen ein neues Plattenpaket möglich. Da der Austausch des Plattenpaketes sehr rasch erfolgt, brauchen in der Regel die in dem Schaltschrank enthaltenen wärmeerzeugenden Geräte und Apparaturen während der Austauschzeit nicht abgeschaltet zu werden, so daß auch keine Maschinenstillstandzeiten anfallen.

Die Verschlußeinrichtungen können an den Kästen angeordnete, das Plattenpaket unverlierbar haltende Halterungselemente aufweisen, von denen wenigstens die Halterungselemente an einem Kasten außer Eingriff mit dem Plattenpaket bringbar sind. Die Halterungselemente können dabei in einer Ausführungsform aus an dem jeweiligen Kasten um eine horizontale Scharnierachse abklappbar gelagerten, das Plattenpaket in einer Verriegelungsstellung übergreifenden Klemmleisten bestehen, während in einer anderen Ausführungsform die Anordnung derart getroffen sein kann, daß die Halterungselemente als an den Kästen angeordnete, das Plattenpaket übergreifende Klemmleisten ausgebildet sind, von denen wenigstens eine abnehmbar ist.

In der Zeichnung sind Ausführungsbeispiele des Gegenstandes der Erfindung dargestellt. Es zeigt

Figur 1 einen Wärmetauscher gemäß der Erfindung, in schematischer perspektivischer Darstellung, teilweise aufgeschnitten,

Figur 2 Elemente des Plattenpakets nach Figur 1, in perspektivischer auseinandergezogener Darstellung,

Figur 3 und 4 den Wärmetauscher nach Figur 1, geschnitten längs der Linie III-III der Figur 1, in einer stark schematisierten Seitenansicht in einem anderen Maßstab sowie unter Veranschaulichung des Zustandes bei betriebseingebautem Plattenpaket und bei teilweise herausgenommenem Plattenpaket und

Figur 5 den Wärmetauscher nach Figur 1, geschnitten längs der Linie III-III der Figur 1, in einer Seitenansicht, teilweise in perspektivischer Darstellung, im Ausschnitt in einem anderen Maßstab, unter Veranschaulichung eines anderen Ausführungsbeispiels.

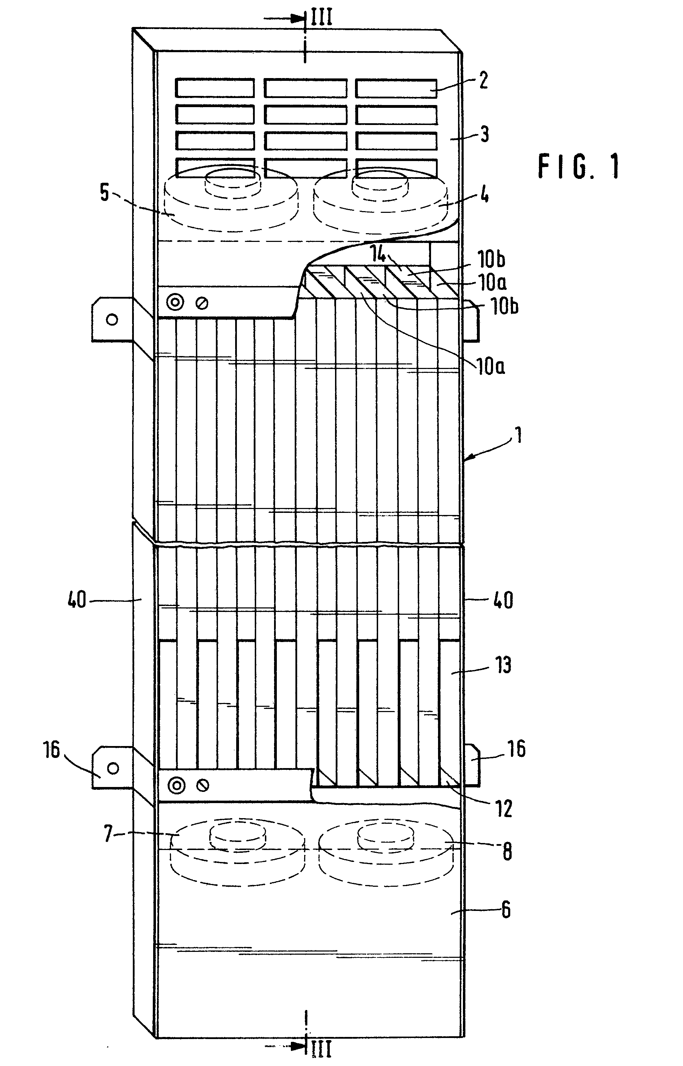

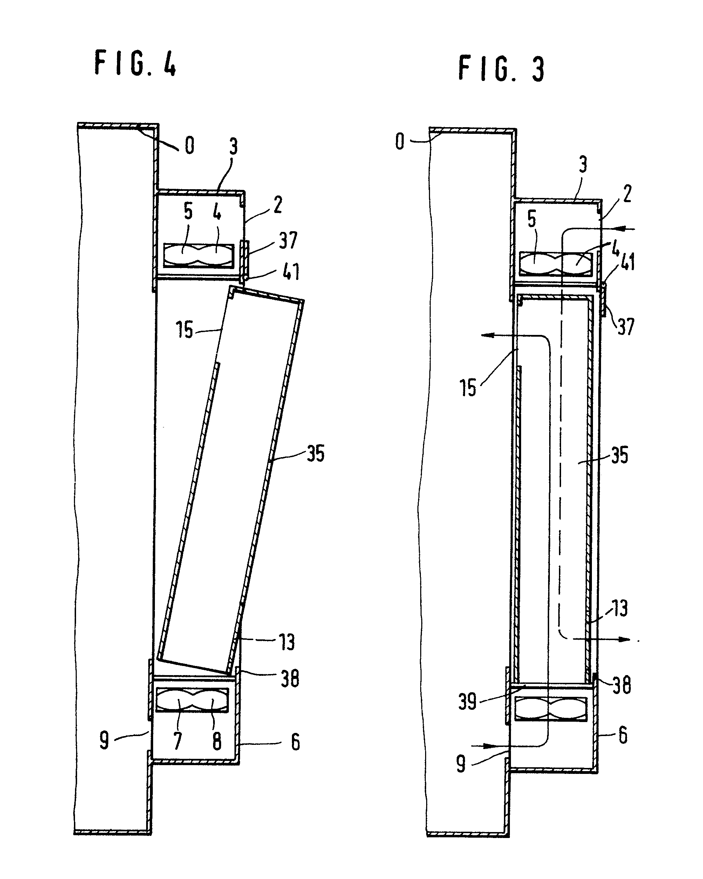

In Figur 1 ist ein Wärmetauscher 1 für zwei Kühlluftkreisläufe dargestellt, der zur staubfreien Luftkühlung eines bei 0 angedeuteten Schaltschrankes dient. Auf seiner oberen Stirnseite sitzt ein mit die Verbindung mit der Außenluft herstellenden Lüftungsschlitzen 2 versehener Kasten 3, in dem zwei durch gestrichelte Linien angedeutete Lüfter 4 und 5 angeordnet sind. Auf der unteren Stirnseite des Wärmetauschers 1 befindet sich ein weiterer Kasten 6, in dem ebenfalls zwei gestrichelt angedeutete Lüfter 4 und 5 angeordnet sind. Auf der unteren Stirnseite des Wärmetauschers 1 befindet sich ein weiterer Kasten 6, in dem ebenfalls zwei gestrichelt angedeutete Lüfter 7 und 8 enthalten sind. Der untere Kasten 6 weist, wie Figur 3 zeigt, eine Öffnung 9 auf, die jedoch in die entgegengesetzte Richtung wie die Lüftungsschlitze 2 des oberen Kastens 3 weist und die Verbindung mit dem Inneren des Schaltschrankes 0 herstellt.

Der Wärmeaustauscher 1 ist durch abwechselnd nebeneinander angeordnete Kanäle 10a und 10b gebildet. Die Kanäle 10a sind nach oben in Richtung auf den Kasten 6 stirnseitig bei 12 verschlossen, während sie an diesem Ende eine seitliche Öffnung 13 aufweisen, durch die die von den Lüftern 4 und 5 in die Kanäle 10a eingeblasene Luft zur Außenluft zurückkehren kann. Die Kanäle 10b sind an ihrem in dem Kasten 3 befindlichen Ende bei 14 abgeschlossen und enthalten, wie Figur 3 zeigt, seitliche, nach hinten in den Schaltschrank weisende Öffnungen 15, während sie an dem in dem Kasten 6 befindliche Ende offen sind. Auf diese Weise kann die von den Lüftern 7 und 8 des unteren Kastens 6 in die Kanäle 10b eingeblasene Luft über die Öffnungen 15 in den Schaltschrank 0 austreten.

Mit Hilfe von an dem Wärmetauscher 1 angebrachten Flanschen 16 ist er an dem Schaltschrank 0 zu befestigen, wonach die Öffnungen 15 und die Öffnung 9 strömungsmäßig mit dem Inneren des Schaltschrankes 0 verbunden sind, während die Lüftungsschlitze 2 sowie die Öffnungen 13 mit der Außenluft in Verbindung stehen.

Die Kanäle 10a und 10b sind jeweils durch Platten 20 gebildet, die aus einem Boden 21 und zwei seitlich abgebogenen Rändern 22 und 23 bestehen, an die nach innen weisende Leisten 24 und 25 angeformt sind. Der Rand 23 ist an einem Ende der Platte 20 verkürzt, so daß eine Ausnehmung 26 zustandekommt, die ihrerseits beim Zusammenbau der einzelnen Platten die Öffnung 13 bzw. 15 bildet. Jeweils im Bereich der Ausnehmung 26 ist jede der Platten 20 mit einem stirnseitigen Rand 27 versehen, der ebenfalls eine angebogene Leiste 28 trägt.

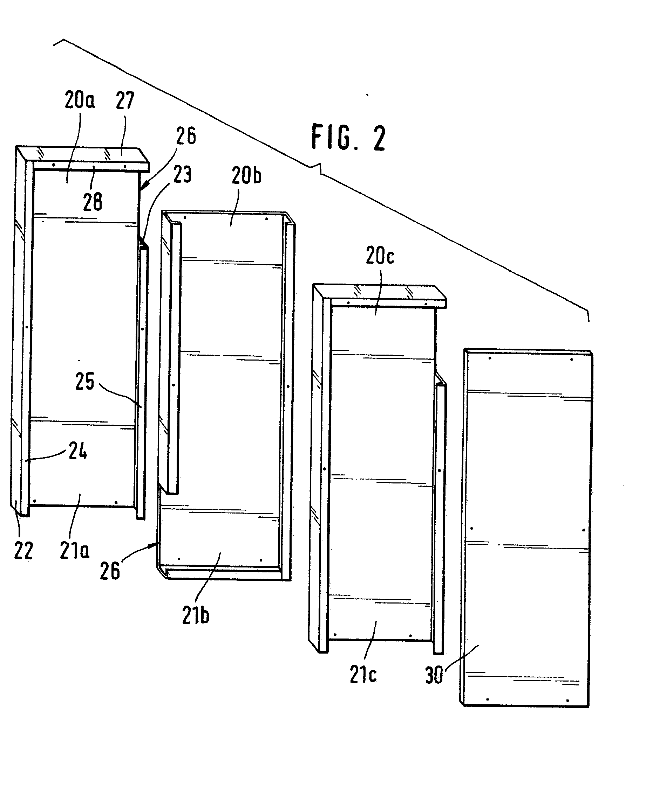

Wie aus Figur 2 ersichtlich, sind alle Platten 20, die gemeinsam den Wärmetauscher 1 bilden, untereinander gleich, jedoch um eine zum Boden 21 rechtwinklig verlaufende Achse um 180° gedreht, so daß die Ausnehmung 26 bei jeder zweiten Platte 20 oben angeordnet ist und, bezogen auf Figur 2, nach rechts weist, während die Ausnehmung 26 der jeweils dazwischen angeordneten Platte 20 unten liegt und, bezogen auf Figur 2, nach links weist.

Beim Zusammenbau des Wärmetauschers 1 wird auf der Platte 20a, deren Ausnehmung 26 oben liegt, die Platte 20b derart angeordnet, daß ihr Boden 21b auf den Leisten 24, 25 der abgebogenen Ränder 22, 23 zu liegen kommt. Die Ausnehmung 26 der Platte 20b liegt hierbei unten. Auf die Platte 20b wird bei der weiteren Montage die Platte 20c aufgesetzt, die wiederum dieselbe Ausrichtung hat wie die Platte 20a. Wenn größere Leistungen abgeführt werden müssen, können weitere Platten 20 abwechselnd mit den Ausnehmungen 26 oben oder unten nebeneinander angeordnet werden. Die jeweils letzte noch gebogene Platte, in Figur 2 die Platte 20c, ist durch eine einfache ebene Platte 30 abgeschlossen.

Die so zusammengesetzten Platten 20 bilden gemeinsam mit der endseitigen Abschlußplatte 30 ein Plattenpaket 35, das einen einheitlichen, im Querschnitt rechteckigen Körper darstellt. Die Platten 20 — und die Abschlußplatte 30 — können miteinander verklebt, verschweißt oder mittels durchgehender Zugbolzen 36 starr miteinander verklemmt sein.

Das Plattenpaket 35 ist, wie aus den Figuren zu ersehen, derart auf die Wand des Schaltschrankes 0 aufgesetzt, daß die Ebenen der Platten 20 rechtwinklig zur Wand des Schaltschrankes verlaufen. Dabei ist das Plattenpaket lösbar mit den die Gebläse 4 bis 8 enthaltenden Kästen 3, 6 verbunden, so daß es von dem Schaltschrank 0 als Ganzes abgenommen werden kann, während die Kästen 3, 6 an der Schrankwand verbleiben. Zur Verbindung des Plattenpaketes 35 mit den Kästen 3, 6 sind jeweils Verschlußeinrichtungen vorgesehen, die ohne Abnahme der Kästen 3, 6 von der Schrankwand wahlweise lösbar sind.

Bei der Ausführungsform nach den Figuren 1, 3 und 4 weisen die Verschlußeinrichtungen an den Kästen 3, 6 angeordnet, das Plattenpaket 35 unverlierbar haltende Halterungselemente in Gestalt von Klemmleisten 37, 38 auf. Die Klemmleisten 37, 38 übergreifen das Plattenpaket 35 in der in Figur 3 dargestellten Betriebsstellung, wobei das Plattenpaket 35 selbst auf dem unteren an der Schrankwand befestigten Kästen 6 bis 39 aufsteht und durch die beiden Kästen 3, 6 miteinander verbindende Seitenwände (Figur 1) seitlich gehalten ist. Von den beiden Klemmleisten 37, 38 ist die obere Klemmleiste 37 an dem zugeordneten Kasten 3 um eine horizontale Scharnierachse 41 wegklappbar gelagert, so daß sie nach Lösen von nicht weiter dargestellten Verriegelungselementen, beispielsweise in Gestalt von Schrauben, aus der Verriegelungsstellung nach Figur 3 in die unwirksame Stellung nach Figur 4 hochgeklappt werden kann. In dieser Stellung kann das Plattenpaket 35, wie in Figur 4 veranschaulicht, zwischen den beiden an der Schrankwand verbleibenden Kästen 3, 6 und den ebenfalls ortsfesten Seitenwänden 40 herausgeklappt und damit entnommen werden. Grundsätzlich ist es naturgemäß denkbar, auch die Klemmleiste 38, ähnlich wie die Klemmleiste 37, wegklappbar an dem zugeordneten Kasten 6 zu lagern.

Das herausgenommene Plattenpaket 35 kann z. B. in einem Lösungsmittelbad gereinigt und sodann wieder eingesetzt werden, worauf die obere Klemmleiste 37 wieder in die Stellung nach Figur 3 abgeklappt und in dieser verriegelt wird. Bei starker Verschmutzung des Plattenpaketes 35 kann es auch gegen ein neues, gereinigtes ausgetauscht werden. Der Austausch geht sehr rasch vonstatten, so daß — wie bereits eingangs erwähnt — eine Betriebsunterbrechung der in dem Schaltschrank 0 angeordneten Betriebsmittel in der Regel nicht erforderlich ist.

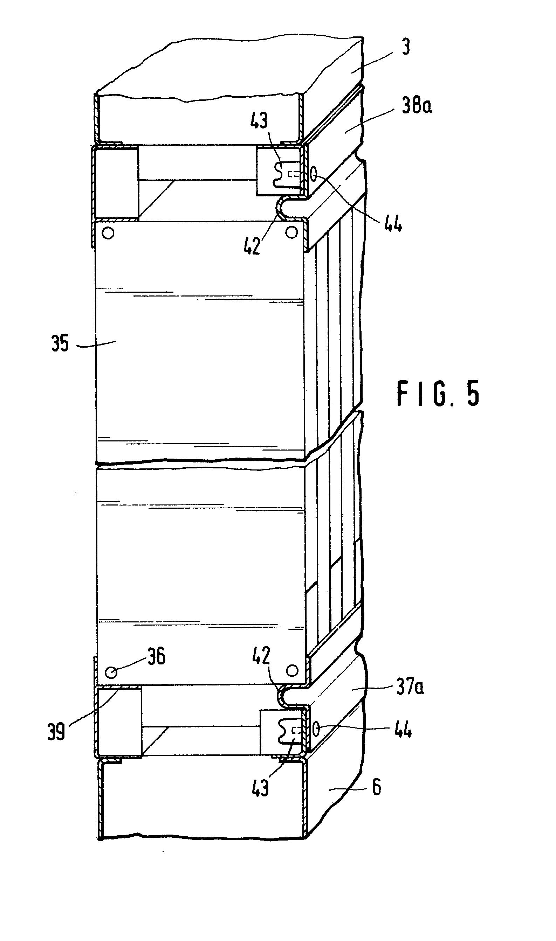

Bei der in Figur 5 veranschaulichten Ausführungsform ist das Plattenpaket 35 ebenfalls auf den unteren Kasten 6 aufgesetzt, und zwar auf Konsolen 39 in der Nähe der Kastenrückseite. Im Bereiche der Kastenvorderseite sind Halterungselemente in Gestalt von das Plattenpaket 35 übergreifenden Klemmleisten 37a, 38a vorgesehen, die eine das Plattenpaket 35 vorne abstützende eingeprägte Sicke 42 aufweisen und an dem Kasten 6 bzw. 3 mittels Schrauben 44 lösbar befestigt sind. Die Schrauben 44 sind in entsprechende Gewindebohrungen aufweisende, an dem Kasten 6 bzw. 3 befestigte Blechlaschen 43 eingeschraubt.

Zur Demontage des Plattenpaketes 35 brauchen lediglich die Schrauben 44 gelöst und die Klemmleisten 37a, 38a abgenommen zu werden, worauf das Plattenpaket 35 bezogen auf Figur 5, nach rechts herausgezogen werden kann, während die Kästen 6, 3 an der Schrankwand verbleiben.

Grundsätzlich ist es auch denkbar, das Plattenpaket 35 derart aufzubauen, daß die die Kanäle 10a, 10b begrenzenden Platten mit ihren hochgebogenen seitlichen Rändern einstückig miteinander verbunden sind, so daß sich ein mäanderförmig gebogenes Blechteil ergibt, das dann mit den entsprechenden Öffnungen 13 bzw. 15 versehen wird.

**Patentansprüche**

1. Zur staubfreien Kühlung eines Schaltschrankes (0) mittels durch Gebläse (4, 5, 7, 8) geförderter Kühlluft dienender und außen an der Schrankwand angeordneter Wärmetauscher (1) mit flachen, dem einen durch den Schaltschrank (0) hindurchgehenden Kühlluftkreislauf zugeordneten ersten Kanälen (10a), zwischen denen flache, zu dem anderen, mit der Außenluft verbundenen Kühlluftkreislauf gehörende zweite Kanäle (10b) wärmeübertragend angeordnet sind, wobei die Kanäle (10a, 10b) aus zu einem endseitig durch eine ebene Platte (30) abgeschlossenen Paket (35) zusammengefügten gleichen Platten (20) mit hochgebogenen seitlichen Rändern (22, 23) und einem an einer Stirnseite hochgebogenen Rand (28) gebildet sind, das Plattenpaket (35) derart angeordnet ist, daß die Ebenen der Platten rechtwinklig zur Wand des Schaltschrankes (0) verlaufen und auf die beiden Enden des Plattenpaketes (35) jeweils die Gebläse (4, 5, 7, 8) enthaltende Kästen (3, 6) aufgesetzt sind, die zur Außenluft führende bzw. mit dem Inneren des Schaltschrankes (0) verbundene Öffnungen (9, 15) aufweisen, dadurch gekennzeichnet, daß das Plattenpaket (35) mit den die Gebläse (4 bis 8) enthaltenen Kästen (3, 6) mittels Verschlußeinrichtungen (37, 38; 37a, 38a) verbunden ist, die bei auf der Schrankwand verbleibenden Kästen (3, 6) lösbar sind.

2. Wärmetauscher nach Anspruch 1, dadurch gekennzeichnet, daß die Verschlußeinrichtung an den Kästen (3, 6) angeordnete, das Plattenpaket (35) unverlierbar halternde Halterungselemente (37, 38) aufweisen, von denen wenigstens die Halterungselemente (37) an einem Kasten (3) außer Eingriff mit dem Plattenpaket (35) bringbar sind.

3. Wärmetauscher nach Anspruch 2, dadurch gekennzeichnet, daß die Halterungselemente aus an den Kästen (3, 6) angeordneten, das Plattenpaket (35) übergreifenden Klemmleisten (37a, 38a) bestehen, von denen wenigstens eine abnehmbar ausgebildet sind.

4. Wärmetauscher nach Anspruch 3, dadurch gekennzeichnet, daß die Klemmleisten (37a, 38a) eine angeformte Abstützung (42) für das Plattenpaket (35) aufweisen.

5. Wärmetauscher nach Anspruch 2, dadurch gekennzeichnet, daß die Halterungselemente aus an dem jeweiligen Kasten (3 bzw. 6) um eine horizontale Scharnierachse (41) wegklappbar gelagerten, das Plattenpaket in einer Verriegelungsstellung übergreifenden Klemmleisten (37) bestehen.

6. Wärmetauscher nach einem der vorhergehenden Ansprüche, dadurch gekennzeichnet, daß das Plattenpaket (35) ein die Kanäle (10a, 10b) begrenzendes mäanderförmig gebogenes Blech enthält.

**Claims**

1. Heat exchanger (1), serving for the dust-free cooling of a switch cabinat (0) by means of cooling air delivered by blowers (4, 5, 7, 8) and arranged externally on the cabinet wall, having flat first passages (10a) allocated to the one cooling air circuit passing through the switch cabinet (0), between which flat second passages (10b) pertaining to the other cooling air circuit connected with the external air are arranged in heat-transmitting manner, the passages (10a, 10b) being formed from similar plates (20), assembled into a pack (35) closed off at the end by a flat plate (30), with bent-up lateral margins (22, 23) and a margin (28) bent up at one end, the plate pack (35) being arranged in such a way that the planes of the plates extend at right angles to the wall of the switch cabinet (0) and boxes (3, 6) containing the blowers (4, 5, 7, 8) being set upon each of the two ends of the plate pack (35), which boxes comprise openings (9, 15) leading to the external air and connected with the interior of the switch cabinet (0) respectively, charcterised in that the plate pack (35) is connected with the boxes (3, 6) containing the blowers (4 to 8) by means of fastener devices (37, 38; 37a, 38a) which are releasable with the boxes (3, 6) remaining on the cabinet wall.

2. Heat exchanger according to Claim 1, characterised in that the fastener devices comprise retaining elements (37, 38) arranged on the boxes (3, 6) and non-losably retaining the plate pack (35), of which retaining elements at least the elements (37) on one box (3) are bringable out of engagement with the plate pack (35).

3. Heat exchanger according to Claim 2, characterised in that the retaining elements consist of fastening straps (37a, 38a) arranged on the boxes (3, 6) and grasping over the plate pack (35), at least one of which straps is removably formed.

4. Heat exchanger according to Claim 3, characterised in that the fastening straps (37a, 38a) comprise integral supports (42) for the plate pack (35).

5. Heat exchanger according to Claim 2, characterised in that the retaining elements consist of fastening straps (37) mounted on the respective box (3 or 6) for hingeing away about a horizontal hinge axis (41) and grasping over the plate pack in a locking position.

6. Heat exchanger according to one of the preceding Claims, characterised in that the plate pack (35) contains a metal sheet bent into serpentine form and limiting the passages (10a, 10b).

## Revendications

1. Echangeur de chaleur (1) servant au refroidissement exempt de poussière d'une armoire de distribution (0) au moyen d'air froid propulsé par des soufflantes (4, 5, 7, 8), installé à l'extérieur sur la paroi de l'armoire, comportant des premiers canaux plats (10a) associés à l'un des circuits d'air de refroidissement traversant l'armoire (0) et entre lesquels sont interposés, pour la transmission de la chaleur, des seconds canaux plats (10b) appartenant à l'autre circuit d'air de refroidissement relié à l'air extérieur, les canaux (10a, 10b) étant formés par des plaques identiques (20) assemblées en un paquet (35) fermé d'un côté par une plaque plane (30) et munies de bords latéraux (22, 23) coudés et d'un bord (28) coudé sur une face frontale, le paquet de plaques (35) étant disposé de manière que les plans des plaques soient perpendiculaires à la paroi de l'armoire de distribution (0) et aux deux extrémités du paquet de plaques (35) sont placés des caissons (3, 6) contenant respectivement les soufflantes (4, 5, 7, 8) et comportant des orifices (9, 15) conduisant à l'air extérieur ou communiquant avec l'intérieur de l'armoire de distribution (0), caractérisé par le fait que le paquet de plaques (35) est relié aux caissons (3, 6) contenant les soufflantes (4 à 8) par des dispositifs de fermeture (37, 38; 37a, 38a) que l'on peut enlever tandis que les caissons (3, 6) restent sur la paroi de l'armoire.

2. Echangeur de chaleur selon la revendication 1, caractérisé par le fait que les dispositifs de fermeture comportent des éléments de retenue (37, 38) disposés sur les caissons (3, 6), fixant de façon imperdable le paquet de plaques (35) et dont au moins les éléments de retenue (37) sur un caisson (3) peuvent être mis hors de prise d'avec le paquet de plaques (35).

3. Echangeur de chaleur selon la revendication 2, caractérisé par le fait que les éléments de retenue sont constitués par des barrettes de serrage (37a, 38a) disposées sur les caissons (3, 6), recouvrant le paquet de plaques (35) et dont au moins une est réalisée amovible.

4. Echangeur de chaleur selon la revendication 3, caractérisé par le fait que les barrettes de serrage (37a, 38a) comportent un appui (42) façonné d'une seule pièce pour le paquet de plaques (35).

5. Echangeur de chaleur selon la revendication 2, caractérisé par le fait que les éléments de retenue sont constitués par des barrettes de serrage (37) qui, sur le caisson (3 ou 6) à chaque fois considérée, sont montées pivotables autour d'un axe de charnière horizontale (41) et recouvrant le paquet de plaques dans une position de verrouillage.

6. Echangeur de chaleur selon l'une des revendications précédentes, caractérisé par le fait que le paquet de plaques (35) comporte une tôle coudée en forme de méandre et délimitant les canaux (10a, 10b).

III

2

3

FIG. 1

5

4

14

10b
10a
10b

10a

1

40

40

13

16

16

12

7

8

6

III

FIG. 2

# FIG. 4

# FIG. 3

FIG. 5